# EUROPÄISCHE PATENTSCHRIFT

(11) **EP 0 753 882 B1**
(45) Veröffentlichungstag und Bekanntmachung des Hinweises auf die Patenterteilung: **18.11.1998**
(21) Anmeldenummer: 96106041.5
(22) Anmeldetag: 18.04.1996
(51) Int. Cl.: H01J 37/34

(54) **Kathodenanordnung für eine Vorrichtung zum Zerstäuben eines Targets**
Cathode assembly for a target sputtering device
Arrangement de cathode pour un dispositif de pulvérisation d'une cible

(30) Priorität: 08.07.1995 DE 19525007
(43) Veröffentlichungstag der Anmeldung: 15.01.1997
(73) Patentinhaber: Balzers und Leybold Deutschland Holding Aktiengesellschaft, 63450 Hanau (DE)
(72) Erfinder: Szczyrbowski, Joachim, Dr., 63773 Goldbach (DE); Marquardt, Dieter, 63526 Erlensee (DE)

(56) Entgegenhaltungen:
- DE-U- 9 313 384
- PATENT ABSTRACTS OF JAPAN Bd. 014, Nr. 130 (E-0901) 12 März 1990 & JP-A-01 319 966 (NEC CORP) 26 Dezember 1989

## Beschreibung

Die Erfindung betrifft eine Kathodenanordnung für eine Vorrichtung zum Zerstäuben eines Targets mit einem Magnetjoch und mit zwischen dem Target und dem Magnetjoch angeordneten Permanentmagneten sowie mit einer Halterung zur Befestigung des Magnetjochs an einem Wandteil der Vakuumkammer.

Der vorliegenden Erfindung liegt die Aufgabe zugrunde, eine Kathode zum Sputtern von insbesondere hochisolierenden Werkstoffen zu schaffen, deren Außenflächen weitgehend frei sind von Unebenheiten, wie z.B. Schraubenköpfen oder Bohrungen und Spalten. Insbesondere aber soll das Auswechseln des Targets auf einfachste Art und Weise besonders rasch und ohne Spezialwerkzeug durchführbar sein.

Diese Aufgabe wird dadurch gelöst, daß das ortsfest gehaltene Magnetjoch auf seiner dem Target abgekehrten Seite an einem Nocken oder Nockenpaar anliegt, das seinerseits an einer Kopfplatte abgestützt ist, die mit dem Magnetjoch über eine Schraube oder Federbolzen mit Spiel verbunden ist, wobei beiderseits des Magnetjochs u-förmig ausgebildete Pratz- oder Klammerleisten vorgesehen sind, deren seitlich abstehende Schenkel oder klauenförmige Randteile jeweils einerseits die Kopfplatte und andererseits das Magnetjoch und/oder die Targetrückenplatte übergreifen.

Weitere Einzelheiten, Abänderungen und Merkmale der Erfindung sind in den unabhängigen Patentansprüchen 3 und 4 und dem abhängigen Anspruch 2 näher gekennzeichnet.

Die Erfindung läßt die verschiedensten Ausführungsmöglichkeiten zu; eine davon ist in den anhängenden Zeichnungen näher dargestellt und zwar zeigen:
- Fig. 1: den Schnitt quer durch eine Zwei-Kathodenanordnung nach der Erfindung,
- Fig. 2: den Schnitt längs durch die Kathodenanordnung nach Fig. 1,

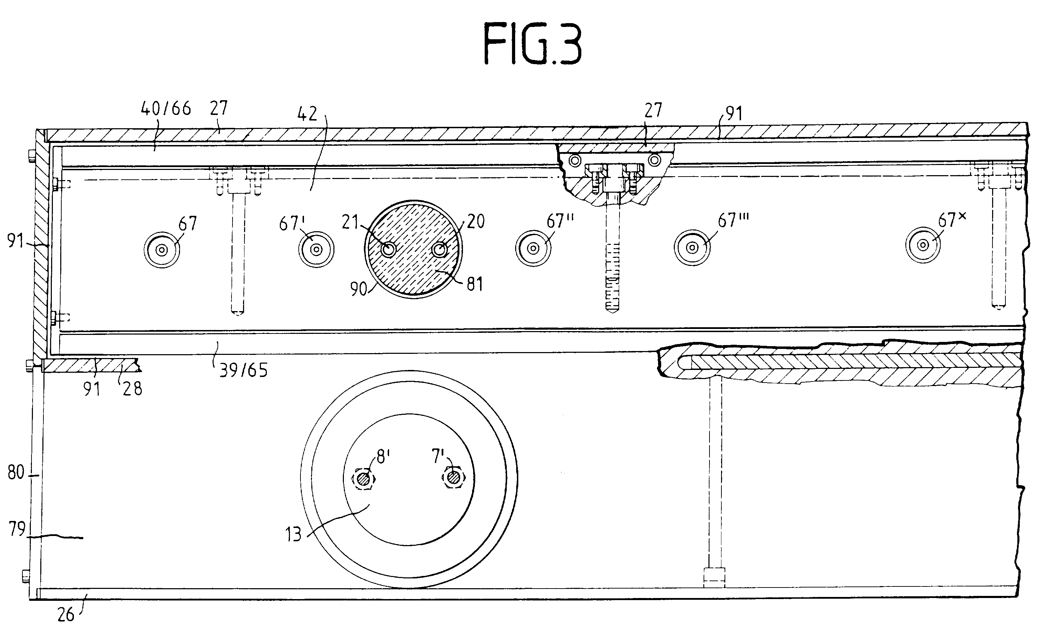

- Fig. 3: die Draufsicht auf die Zwei-Kathodenanordnung nach den Figuren 1 und 2, teilweise im Schnitt,
- Fig. 4: einen Schnitt quer durch eine Kathode in vergrößerter Darstellung und
- Fig. 5: den Schnitt quer durch die Kathodenanordnung nach Fig. 1, jedoch mit von der Mittelplatte entfernten Kathoden.

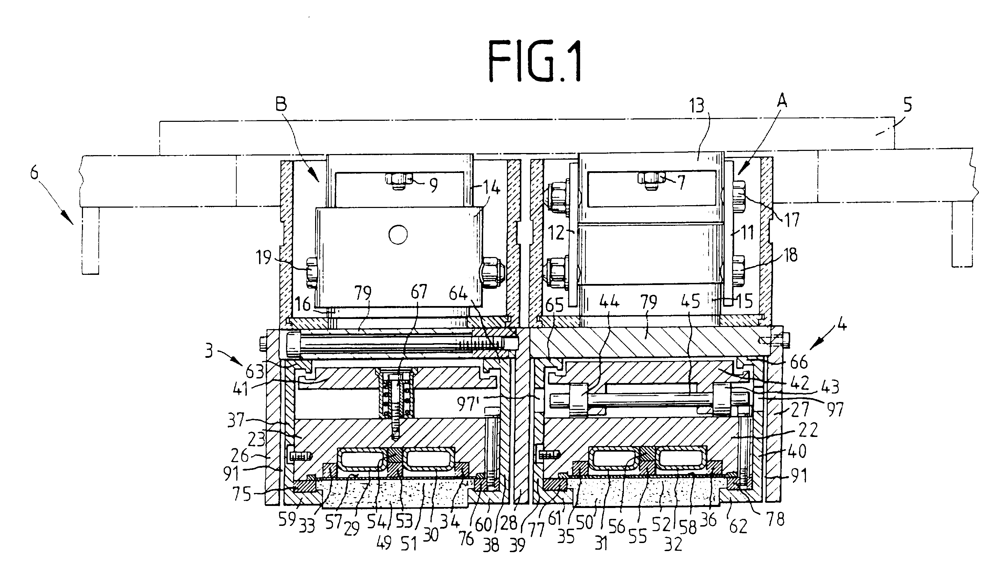

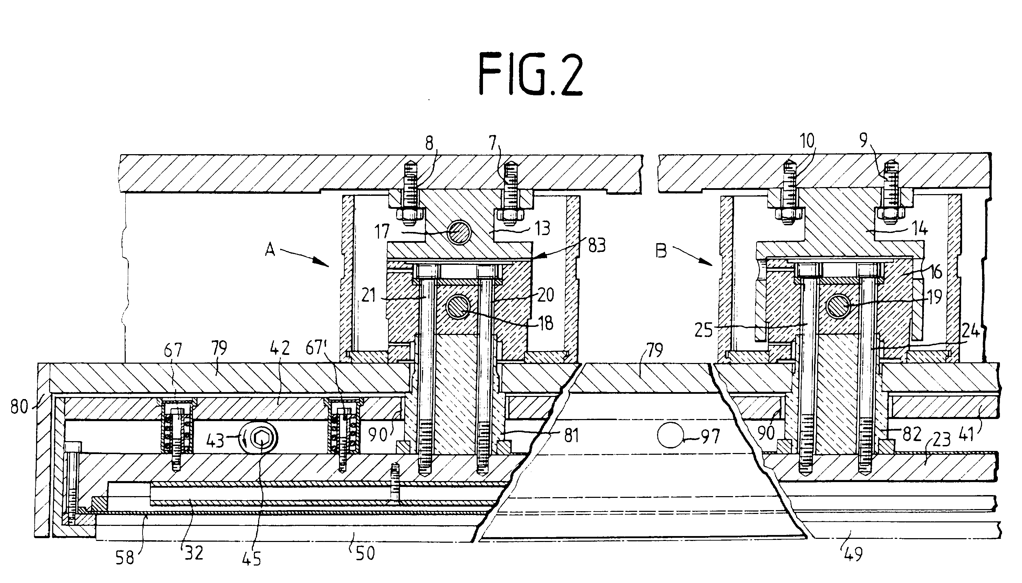

Wie Fig. 1 zeigt, sind die beiden Kathoden 3, 4 am oberen Wandteil 5 der Vakuumkammer 6 mit Hilfe von Schrauben 7, 8 bzw. 9, 10 befestigt, wobei die Kathoden 3, 4 selbst jeweils entweder über Kettenglieder bildende Laschen-Paare 11, 12 mit Lagerböcken 13 und Isolatoren 15, über Schrauben 17, 18 oder über mit den Lagerböcken 14 mit Schrauben 19 direkt verbundene Isolatoren 16 gekoppelt sind. Die Isolatoren 15, 16 ihrerseits sind mit Hilfe von Stehbolzen 20, 21 bzw. 24, 25 mit den Magnetjochs 22, 23 verschraubt (Figur 2), so daß die Kathoden 3, 4 zusammen mit den sie umschließenden Seitenplatten 26, 27 ,28, den Magnetjochs 22, 23, den Kühlrohren 29, 30 bzw. 30, 31, den Permanentmagneten 33, 34 bzw. 35, 36 bzw. 53, 54 bzw. 55, 56 den Klammerleisten 37, 38 bzw. 39, 40, den Kopfplatten 41 bzw. 42, den Nocken 43,44 mit Nokkenwelle 45 und Federbolzen 67,67',... und den Targets 49 bzw. 50 mit ihren Rückenplatten 51 bzw. 52 an dem oberen Wandteil 5 hängen.

Die Targets 49, 50 bzw. ihre Rückenplatten 51, 52 werden mit Hilfe der Klammerleisten 37 bis 40 jeweils gegen die Membrane 57, 58 gepreßt, da ihre dem Substrat zugekehrten Randpartien 59 bis 62 die Rückenplatten 51, 52 überdecken und diese jeweils fest gegen die Magnetjoche 22, 23 ziehen, wozu die den Rückenplatten abgekehrten Randteile 63 bis 66 die Kopfplatten 41, 42 übergreifen, die im übrigen jeweils mit Hilfe der Schrauben 67, 67' mit den Magnetjochen 22,23 verbunden sind.

Um die Targets 49, 50 fest mit den Magnetjochen 22, 23 zu koppeln, werden die Nockenwellen 45,45',... so weit gedreht, daß sich einerseits die Kopfplatten 41, 42 fest an die oberen Randteile 63 bis 66 und andererseits die unteren Randteile 59 bis 62 fest an die Distanzleisten 75 bis 78 anlegen und alle von den Klammerleisten 37 bis 40 umgriffenen Teile fest miteinander verbinden. Da die Lagerböcke 13, 14 fest mit den Magnetjochen 22, 23 mit Hilfe der Schrauben 20, 21 bzw. 24, 25 verbunden sind, werden sie vom oberen Wandteil 5 der Vakuumkammer 6 gehalten. Gleichzeitig stützen sich auch die Deckplatte 79 auf den Isolatoren 81, 82 ab, die ihrerseits von den Schrauben 20, 21 bzw. 24, 25 gehalten sind. Dadurch, daß zwischen dem Lagerbock 13 einerseits und dem Isolator 15 andererseits, ein Spalt 83 vorgesehen ist, können die Kathoden 3, 4 eine bestimmte Bewegung gegenüber der in Fig. 2, rechts dargestellten Aufhängung in horizontaler Ebene ausführen (da die Isolatoren 15, 16 einerseits und die Lagerböcke 13, 14 gelenkig über die Laschen 11, 12 bzw. die Schrauben 17, 18 verbunden sind und somit nach Art eines Kettengliedes wirken) . Die Kathoden 3, 4 sind sehr lang ausgebildet, wobei jeder der beiden langen Kathoden 3, 4 an mehreren jeweils über ihre Länge verteilt angeordneten Aufhängungen des (in Fig. 2 links dargestellten) Typs A und jeweils einer Aufhängung des (in Fig. 2 rechts dargestellten) Typs B am oberen Wandteil 5 befestigt sind, wobei die Aufhängung des Typs A eine Verschiebung des Magnetjochs 22 mit allen an ihr befestigten Einzelteilen in Kathodenlängsrichtung gestattet, wozu das Magnetjoch 22 bzw. die Isolatoren 81, 15 über ein Laschenpaar 11, 12 pendelnd am ortsfesten Lagerbock 13 gehalten sind. Bei der Aufhängung des Typs B ist eine Pendelbewegung des Magnetjochs 23 nicht vorgesehen, weshalb die Isolatoren 82, 16 starr mit dem Lagerbock 14 verbunden sind. Die verschiedenen Aufhängungstypen A bzw. B gestatten die Längendehnung der Kathode infolge ihrer Temperaturerhöhung während des Beschichtungsvorgangs.

Durch die umhüllende Anordnung ist der Kathodenkörper gegen Aufsputtern von Schichten geschützt. Die Pratzleisten bzw. Klammerleisten 37 bis 40 befestigen das Target 49, 50 und spannen es formschlüssig gegen die Membrane 57, 58. Die Klammerleistenreihen sind mehrteilig und ermöglichen durch getrennte Fixierung eine kontrollierte Längenausdehnung bei kleinstem Spalt 90, 91. Die in Richtung Substrat weisende Seite ist glatt und verhindert lokale Prozeßunstabilitäten, wie insbesondere das Arcing.

Durch den Wegfall vieler Schrauben und das einfache Lösen durch Drehen der Wellen 45,45',... mit Hilfe eines Innensechskantschlüssels ist ein schneller Targetwechsel möglich.

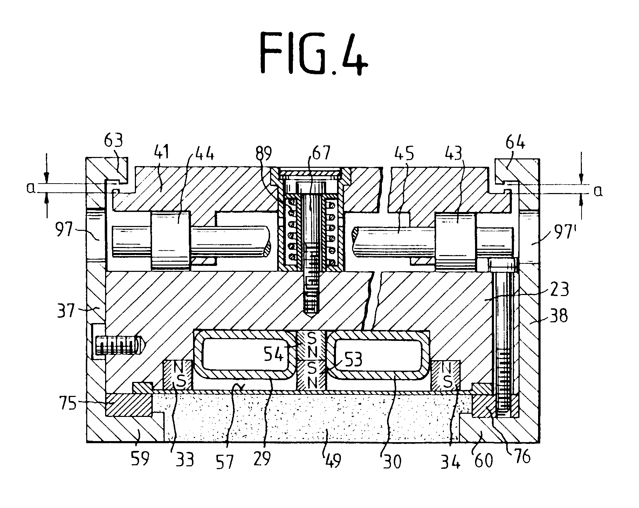

Die Verriegelung und das Verspannen erfolgt durch an der Kopfplatten 41,42 drehbar gelagerten Wellen 45,45',... , auf denen Nocken oder Exzenter 43,43',... fest angeordnet sind, die sich auf den Oberseiten der Magnetjoche 22,23 abstützen. Die Nockenhöhe bzw. die Exzentrizität ist dabei so bemessen, daß sie mindestens dem Spalt "a" entspricht (siehe Figur 4). Um ein zum Drehen der Wellen 45,45',... geeignetes Werkzeug in die Stirnseiten der Wellen 45,45',... einführen zu können, sind in den Klammerleisten 37,38 bzw. 39,40 entsprechende mit den Wellen 45,45',... fluchtende Bohrungen 97,97',... vorgesehen. Beim Entriegeln werden durch Federkraft die Verschlußplatten oder Kopfplatte 41, 42 angehoben und die Klammerleisten 37 bis 40 freigegeben. Die Betätigung der Schraube erfolgt vorteilhaft an der nach außen gerichteten Kathodenseite. Die Gefahr von Targetbeschädigungen bei Targetwechsel ist dadurch vermindert. Die Möglichkeit des Beschichtens der Schrauben ist minimiert und ein einfacher Targetwechsel sichergestellt.

### Bezugszeichenliste

- 3: Kathode
- 4: "
- 5: oberes Wandteil
- 6: Vakuumkammer
- 7: Schraube
- 8: "
- 9: "
- 10: "
- 11: Lasche
- 12: "
- 13: Lagerbock
- 14: "
- 15: Isolator
- 16: "
- 17: Schraube
- 18: "
- 19: "
- 20: Stehbolzen
- 21: "
- 22: Magnetjoch
- 23: "
- 24: Stehbolzen
- 25: "
- 26: Seitenplatte
- 27: "
- 28: Mittelplatte
- 29: Kühlrohr
- 30: "
- 31: "
- 32: "
- 33: Permanentmagnet
- 34: "
- 35: "
- 36: "
- 37: Klammerleiste
- 38: "
- 39: "
- 40: "
- 41: Kopfplatte
- 42: "
- 43,43',...: Nocken, Exzenter
- 44,44',...: "
- 45,45',...: Nockenwelle, Exzenterwelle
- 49: Target
- 50: "
- 51: Rückenplatte
- 52: "
- 53: Permanentmagnet
- 54: "
- 55: "
- 56: "
- 57: Membrane
- 58: "
- 59: Randteil
- 60: "
- 61: "
- 62: "
- 63: Randteil
- 64: "
- 65: "
- 66: "
- 67, 67',...: Schraube, Federbolzen
- 75: Distanzleiste
- 76: "
- 77: "
- 78: "
- 79: Deckplatte, Grundplatte
- 80: Stirnplatte
- 81, 81',...: Isolator
- 82: "
- 83: Spalt
- 89,89',...: Feder
- 90: Öffnung, Spalt
- 91: "
- 97,97',...: "

## Patentansprüche

1. Kathodenanordnung für eine Vorrichtung zum Zerstäuben eines Targets (49 bzw. 50) mit einem Magnetjoch (22, 23) und mit zwischen dem Target und dem Magnetjoch angeordneten Reihen von Permamentmagneten (33, 34, 53, 54 bzw. 35, 36, 55, 56), sowie mit einer Halterung (A bzw. B) zur Befestigung des Magnetjochs (22 bzw. 23) an einem Wandteil (5) der Vakuumkammer (6), dadurch gekennzeichnet, daß das ortsfest gehaltene Magnetjoch (22 bzw. 23) auf seiner dem Target (49 bzw. 50) abgekehrten Seite an einem Nocken oder Nockenpaar (43, 44 bzw. 43', 44') einer auf der Kopfplatte (41) drehbar gelagerten Nockenwelle (45) anliegt, das zum Zwecke des Zusammenspannens der einzelnen Teile der Kathode an einer Kopfplatte (41 bzw. 42) abgestützt ist, die mit dem Magnetjoch (22 bzw. 23) über eine Schraube oder Federbolzen (67, 67',...) mit Spiel (a) verbunden ist, wobei beiderseits des Magnetjochs (22 bzw. 23) u-förmig ausgebildete Pratz- oder Klammerleisten (37, 38 bzw. 39, 40) vorgesehen sind, deren seitlich abstehende Schenkel oder klauenförmige Randteile (59 bis 66) jeweils einerseits die Kopfplatte (41 bzw. 42) und andererseits das Magnetjoch (22 bzw. 23) und/oder die Targetrückenplatte (51 bzw. 52) übergreifen.

2. Kathodenanspruch nach Anspruch 1, dadurch gekennzeichnet, daß das ortsfest gehaltene Magnetjoch auf seiner dem Substrat abgekehrten Seite an einem Nocken oder Nockenpaar anliegt oder sich an diesem abstützt, das seinerseits mit den oberen klauenförmigen Randteilen von zwei u-förmig ausgebildeten Pratz- oder Klammerleisten zusammenwirkt, wobei die beiderseits des Magnetjochs angeordneten Klammerleisten mit ihren unteren klauenförmigen Randteilen die dem Substrat zugekehrte Fläche des Magnetjochs oder der Rückenplatte oder des Targets umgreifen.

3. Kathodenanordnung für eine Vorrichtung zum Zerstäuben eines Targets mit einem Magnetjoch und mit zwischen dem Target und dem Magnetjoch angeordneten Reihen von Permamentmagneten sowie mit einer Halterung zur Befestigung des Magnetjochs an einem Wandteil der Vakuumkammer dadurch gekennzeichnet, daß auf dem ortsfest gehaltenen Magnetjoch auf der dem Target abgekehrten Seite eine Nockenwelle gelagert ist und sich die Nocken zum Zwecke des Zusammenspannens der einzelnen Teile der Kathode an einer Kopfplatte abstützen, wobei die Kopfplatte mit dem Magnetjoch über eine Schraube oder Federbolzen mit Spiel verbunden ist und beiderseits des Magnetjochs u-förmig ausgebildete Pratz- oder Klammerleisten vorgesehen sind, deren seitlich abstehende Schenkel oder klauenförmige Randteile jeweils einerseits die Kopfplatte und andererseits das Magnetjoch und/oder die Targetrückenplatte übergreifen.

4. Kathodenanordnung für eine Vorrichtung zum Zerstäuben eines Targets mit einem Magnetjoch und mit zwischen dem Target und dem Magnetjoch angeordneten Reihen von Permamentmagneten sowie mit einer Halterung zur Befestigung des Magnetjochs an einem Wandteil der Vakuumkammer, dadurch gekennzeichnet, daß beiderseits des Magnetjochs u-förmig ausgebildete Pratz- oder Klammerleisten vorgesehen sind, deren seitlich abstehende Schenkel oder klauenförmige Randteile jeweils einerseits das Magnetjoch und/oder die Targetrückenplatte übergreifen und sich andererseits zum Zwecke des Zusammenspannens von Target und Magnetjoch an dem Nocken einer Nockenwelle abstützen, die an der dem Target abgekehrten Seite des Magnetjochs gelagert ist.

## Claims

1. Cathode assembly for a device for sputtering a target (49 or 50), with a magnet yoke (22, 23), with rows of permanent magnets (33, 34, 53, 54 or 35, 36, 55, 56) arranged between the target and the magnet yoke, and with a holder (A or B) for securing the magnet yoke (22 or 23) to a wall part (5) of the vacuum chamber (6), characterised in that, on its side which is remote from the target (49 or 50), the magnet yoke (22 or 23), which is held stationary, bears against a cam or cam pair (43, 44 or 43', 44') of a camshaft (45) rotatably mounted on the head plate (41), which cam pair, for the purpose of clamping together the individual parts of the cathode, is supported at a head plate (41 or 42) which is connected with clearance (a) to the magnet yoke (22 or 23) via a screw or spring bolt (67, 67',...), wherein u-shaped claw or clamp bars (37, 38 or 39, 40) are provided on both sides of the magnet yoke (22 or 23), the laterally projecting limbs or claw-shaped edge parts (59 to 66) of which bars in each case engage over the head plate (41 or 42) on one side and the magnet yoke (22 or 23) and/or the target back plate (51 or 52) on the other side.

2. Cathode claim according to claim 1, characterised in that, on its side which is remote from the substrate, the magnetic yoke, which is held stationary, bears against or is supported at a cam or cam pair, which cam pair in turn cooperates with the upper claw-shaped edge parts of two u-shaped claw or clamp bars, wherein the clamp bars, which are arranged on both sides of the magnet yoke, embrace the face of the magnet yoke or of the back plate or of the target which faces the substrate with their lower claw-shaped edge parts.

3. Cathode assembly for a device for sputtering a target, with a magnet yoke, with rows of permanent magnets arranged between the target and the magnet yoke, and with a holder for securing the magnet yoke to a wall part of the vacuum chamber, characterised in that a camshaft is mounted on the magnet yoke, which is held stationary, on the side which is remote from the target and, for the purpose of clamping together the individual parts of the cathode, the cams are supported at a head plate, wherein the head plate is connected with clearance to the magnet yoke via a screw or spring bolt, and u-shaped claw or clamp bars are provided on both sides of the magnet yoke, the laterally projecting limbs or claw-shaped edge parts of which bars in each case engage over the head plate on one side and the magnet yoke and/or the target back plate on the other side.

4. Cathode assembly for a device for sputtering a target, with a magnet yoke, with rows of permanent magnets arranged between the target and the magnet yoke, and with a holder for securing the magnet yoke to a wall part of the vacuum chamber, characterised in that u-shaped claw or clamp bars are provided on both sides of the magnet yoke, the laterally projecting limbs or claw-shaped edge parts of which bars in each case engage over the magnet yoke and/or the target back plate on one side and, for the purpose of clamping together the target and the magnet yoke, are supported on the other side at the cam of a cam shaft which is mounted on the side of the magnet yoke which is remote from the target.

## Revendications

1. Dispositif de cathodes pour une installation de pulvérisation d'une cible (49 ou 50), comportant une culasse magnétique (22, 23) et des rangées d'aimants pcrmanents (33, 34, 53, 54 ou 35, 36, 55, 56) disposées entre la cible et la culasse magnétique ainsi qu'un support (A ou B) pour fixer la culasse magnétique (22 ou 23) à une partie de paroi (5) de la chambre à vide (6), caractérisé par le fait que la culasse magnétique (22 ou 23) maintenue fixe en position s'appuie, sur sa face opposée à la cible (49 ou 50), contre une came ou une paire de cames (43, 44 ou 43', 44') d'un arbre à cames (45) porté, avec liberté de rotation, sur le plateau de tête (41), paire de cames qui, dans le but de brider les différentes parties de la cathode, s'appuie contre un plateau de tête (41 ou 42) qui est relié, avec un jeu (a), à la culasse magnétique (22 ou 23) par l'intermédiaire d'une vis ou d'un boulon à ressort (67, 67',...), dans lequel, des deux côtés de la culasse (22 ou 23), sont prévues des tringles à griffes ou à agrafes (37, 38 ou 39, 40), dont les ailes saillant latéralement ou rebords en forme de griffes (59 à 66) saisissent chacune par-dessus d'une part le plateau de tête (41 ou 42) et d'autre part la culasse magnétique (22 ou 23) et/ou le plateau arrière (51 ou 52) de la cible.

2. Dispositif de cathodes selon la revendication 1, caractérisé par le fait que la culasse magnétiquc maintenue fixe en position, se place, par son côté opposé au substrat, contre unc came ou une paire de cames ou s'appuie contre elle, paire de cames qui, de son côté, collabore avec deux tringles à griffes ou à agrafes, en forme de u, dans lequel les tringles à agrafes, disposées des deux côtés de la culasse magnétique, enserrent, par le rebord inférieur en forme de griffe, la surface, située du côté du substrat, de la culasse magnétique ou du plateau arrière ou de la cible.

3. Dispositif de cathodes pour une installation de pulvérisation d'une cible, comportant une culasse magnétique et des rangées d'aimants permanents disposées entre la cible et la culasse magnétique ainsi qu'un support pour fixer la culasse magnétique à une partie de paroi de la chambre à vide, caractérisé par le fait que, sur la culasse magnétiquc maintenue fixe en position, porte, du côté opposé à la cible, un arbre à cames et que, dans le but de brider les différentes parties de la cathode, les cames s'appuient contre un plateau de tête, dans lequel le plateau de tête est relié, avec un jeu, à la culasse magnétique par l'intermédiaire d'une vis ou d'un boulon à ressort et dans lequel, des deux côtés de la culasse, sont prévues des tringles à griffes ou à agrafes, dont les ailes saillant latéralement ou rebords en forme de griffes saisissent chacune par-dessus d'une part le plateau de tête et d'autre part la culasse magnétique et/ou le plateau arrière de la cible.

4. Dispositif de cathodes pour une installation de pulvérisation d'une cible, comportant une culasse magnétique et des rangées d'aimants permanents disposées entre la cible et la culasse magnétique ainsi qu'un support pour fixer la culasse magnétique à une partie de paroi de la chambre à vide, caractérisé par le fait que, des deux côtés de la culasse magnétique, sont prévues des tringles à griffes ou à agrafes en forme de u, dont les ailes saillant latéralement ou les rebords en forme de griffes d'une part saisissent chacune par-dessus la culasse magnétique et/ou le plateau arrière de cible et d'autre part, dans le but de brider la cible et la culasse magnétique, s'appuient contre les cames d'un arbre à cames qui portent sur la face de la culasse magnétique opposée à la cible.
